# EUROPEAN PATENT SPECIFICATION

(11) **EP 3 067 992 B1**
(45) Date of publication and mention of the grant of the patent: **03.04.2024**
(21) Application number: 15158971.0
(22) Date of filing: 13.03.2015
(51) Int. Cl.: H01R 13/514, H01R 13/66, H03K 17/95, H01R 31/06, B29C 45/14, H01R 13/504, H01R 13/627, H01R 12/58, H01R 12/72

(54) **Electrical connector kit, electronic component, and assembly method**
Elektrisches Verbinderkit, elektronisches Bauteil und Montageverfahren
Ensemble connecteur électrique, composant électronique et procédé d'assemblage

(43) Date of publication of application: 14.09.2016
(73) Proprietor: TE Connectivity Germany GmbH, 64625 Bensheim (DE)
(72) Inventor: Walldorf, Daniel, 65795 Hattersheim (DE); Buscemi, Calogero Mauro, 79111 Freiburg im Breisgau (DE); Strelow, Markus, 69509 Mörlenbach (DE); Schrettlinger, Christian, 64625 Bensheim-Auerbach (DE); Wolf, Frank, 63110 Rodgau-Juegesheim (DE); Burger, Steffen, 60316 Frankfurt am Main (DE); Buechling, Chris, 55283 Nierstein (DE); Laub, Mike, 64625 Bensheim (DE); Buchmann, Ulrich, 64859 Eppertshausen (DE)
(74) Representative: Grünecker Patent- und Rechtsanwälte PartG mbB

(56) References cited:
- EP-A2- 1 398 878
- EP-A2- 2 278 669
- GB-A- 2 511 389
- US-A1- 2010 003 857
- DIXON D ET AL: "THE INDUCTIVE PROX: AN OLD SENSOR WITH NEW WRINKLES", CONTROL SOLUTIONS, PENNWELL PUBLISHING, TULSA, OK, US, vol. 62, no. 10, 31 October 1989 (1989-10-31), pages 55-58, XP000072564, ISSN: 1074-2328

## Description

The present invention relates to an electrical connector kit for an electronic component and in particular for an inductive proximity sensor. Furthermore, the present invention relates to an assembly method for fabricating such an electronic component.

The principles according to the present invention can be used advantageously for inductive sensors, and especially for proximity sensors. Inductive sensors are well known in the art and usually comprise a coil that is wound around a ferrite core and is used to form an oscillator. The inductive proximity sensor comprises a circuit board which is equipped with integrated circuits, for instance an electronic analyzing unit and an amplifying circuit. When a metallic object approaches the sensor, the oscillator is detuned and thus a signal in response to the approaching object can be generated. Such inductive proximity sensors are components fabricated in mass production and therefore the assembly has to be simple and cost-efficient.

Typically, all components of the sensor are integrated within an elongated housing: The sensor coil is arranged at a front end of the sensor, whereas a peripheral contact element for connecting the sensor to external electronic components, i. e. a plug connector or an electrical lead, is arranged at the opposing back end of the sensor. A circuit carrier, usually a printed circuit board (PCB), carries the sensor electronics and is electrically connected to the peripheral contact element.

There exist different concepts for equipping industrial sensors with a plug connector forming the peripheral contact element. A conventional plug connector is screwed or pressed into the housing and can then be connected to the PCB by means of electrically conductive leads which are manually soldered. Alternatively, a flexible printed circuit board can be soldered directly to the plug connector. Finally, a conventional plug connector can be assembled with a cable and an edge connector which is connected to the PCB. In particular the latter variant has the disadvantage that it needs a lot of space.

It is further known to directly assemble the plug connector on the PCB and mount the PCB with the plug connector in a housing, so that the plug connector stays accessible via a suitable opening in the housing.

According to a further conventional arrangement, a plurality of contact pins are assembled individually on the PCB and allowed to extend to the outside through a respective support structure in the housing.

Finally, it is known to form a plug connector at the housing by means of an overmolding technique and to contact the PCB by means of a lead frame which is pressed-in or soldered to the PCB.

EP 1 398 878 A2 discloses a proximity sensor with a pin connector as peripheral connector. The connector has a conductive terminal assembly including a plug-adaptable conductive terminal electrically connected with a circuit assembly and a pin holder for holding the conductive terminal. The terminal assembly is sized to be able to be inserted from the front-end side of an outer shell case. A cylindrical holding member has openings at both ends to enable the conductive terminal assembly to be inserted, a joint to position the conductive terminal assembly to itself, and is fixed from the rear-end side of the outer shell case. In addition, the detection coil assembly and the conductive terminal assembly are electrically connected with each other via a flexible connection member.

Dixon, D. et al.: "The inductive prox: An old sensor with new wrinkles", CONTROL SOLUTIONS, PENNWELL PUBLISHING, TULSA, OK, US, vol. 62, no. 10, 31 October 1989 (1989-10-31), pages 55 - 58, XP000072564, ISSN: 1074-2328, gives an overview over inductive proximity sensors in general.

GB 2511389 A discloses an assembled connecting device with a protective sleeve. The assembled connecting device comprises a connector or adapter and a protective sleeve to protect the connector or adapter from damage caused by dust and scratching. In a first example, the assembled connecting device comprises a first connector with a plugging portion and a protective sleeve with a sheath that is movably coupled to, and selectively envelopes, the first connector. The sheath selectively sleeves at least a portion of the first connector or the plugging portion of the first connector. The protective sleeve has two link arms movably coupled to the first connector, wherein the link arms are slidably connected to the sheath. The top and bottom portions of the sheath may have a pressing part with an anti-slipping surface. In a second example, the assembled connecting device comprises an adapter with two connectors electrically connected together (e.g. via a circuit board) and a protective sleeve with a sheath that is movably coupled to, and selectively envelopes, the adapter. An outer case may cover the two connectors of the adapter.

EP 2 278 669 A2 discloses a portable power supply adapter comprising a casing, a mains power supply cable extending from the casing for connection to a mains power supply, and a portable computer power supply cable extending from the casing for connection to a portable computer. The casing includes power supply circuitry, the casing having an upwardly facing surface, the surface including a plurality of sockets, each adapted to receive a portable electric device and arranged so that a plurality of portable electric devices may be charged from the mains power supply directly whether or not a portable computer is connected to the portable computer power supply cable for charging.

US 2010/003857 A1 discloses an electrical connector assembly which includes a first and a second connector each including an insulating housing and a plurality of terminals retained in the housing. The housing has a front mating portion, a rear face, and a pair of first retaining portions at opposite ends of the rear face of the insulating housing. The terminals include leg portions extending out of the rear face of the housing. A receiving cavity is defined between the pair of retaining portions of the first connector. A transition board is vertically received in the receiving cavity of the first connector and the two pairs of retaining portions are engaged with each other to assembly the two connectors together.

Some applications require that the sensor is equipped with a cable of a suitable length, a so-called pigtail, instead of a plug connector. Such a cable can firstly be soldered manually to the printed circuit board. Secondly, the cable can be provided with an edge connector which is a rather space consuming concept. Conventional cable connections achieve a sealed encapsulation of the sensor components as well as the necessary strain relief by providing an additional overmolding step. Alternatively, a cable gland (also called PG, Panzergewinde, threaded fitting) is often used for providing sealing and strain relief.

When fabricating such an inductive sensor, it is desirable to introduce the distinction concerning the particular peripheral contact element at a point within the assembly process as late as possible and preferably without manual soldering steps. The object underlying the present invention therefore is to provide an electrical connector kit for a circuit carrier that provides a particularly robust and reliable electrical contacting of the circuit carrier and whereby the assembly of a plug connector or a cable is delayed to an assembly step late in the fabrication process.

This object is solved by the subject matter of the independent claims. Advantageous embodiments of the present invention are the subject matter of several dependent claims.

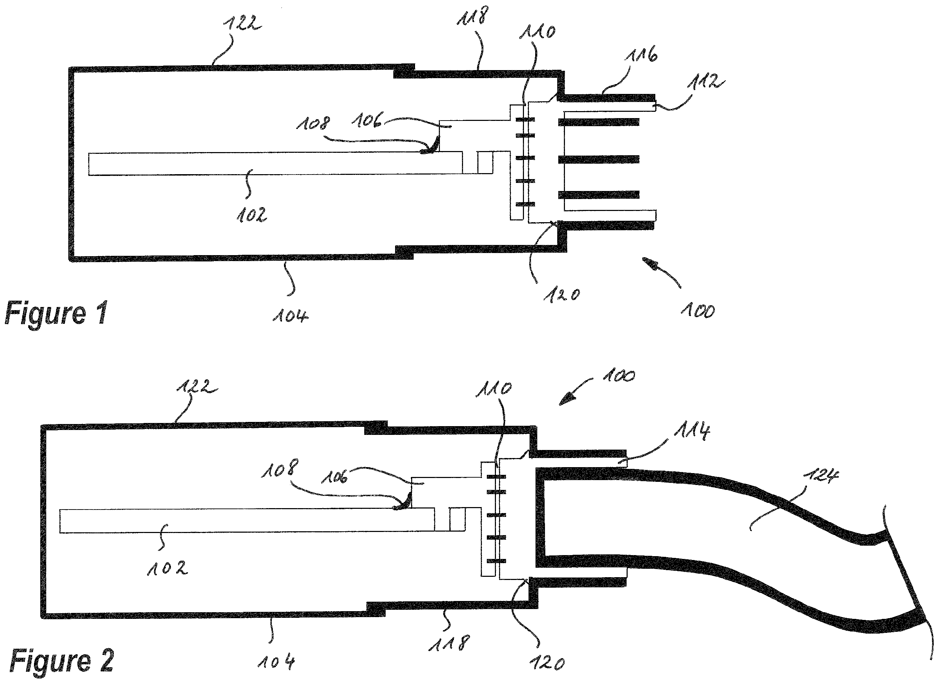

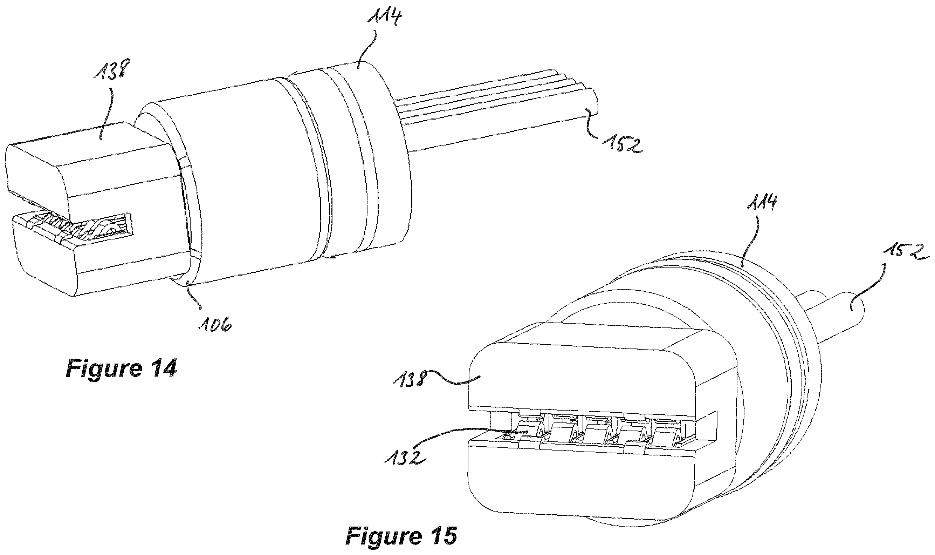

Enabling disclosure can be found, for example, in Figs. 1 to 6. Figures 14 to 20 are useful for understanding the invention.

The present invention is based on the idea that by providing an electrical connector kit for a circuit carrier with at least one interface element which is attachable to the circuit carrier and has at least one inner contact for contacting at least one electrically conductive lead on the circuit carrier and further comprises an electrically connecting interface for contacting a peripheral connector, the decision on the particular peripheral connector can be postponed until one of the very last fabrication steps. According to the present invention, the kit comprises a set of at least one first and second peripheral connector each being connectable to the connecting interface of the interface element. The first and second peripheral connectors are characterized by different peripheral contact elements, such as a plug connector or an electrical lead, for contacting an external electronic component. For connecting the interface element to the circuit carrier, reliable automated techniques can be used. Hence, the connection between the circuit board and the peripheral connector is much more reliable than manually soldered connections.

According to an advantageous example, the peripheral contact region of the first peripheral connector comprises a plug connector, for instance a male plug connector which can be connected to a mating female plug connector belonging to an external electronic component. The second peripheral connector may comprise as its peripheral contact element an electrical lead for forming a pigtail. Thus, all requirements regarding a particular type of peripheral contact element can easily be fulfilled.

According to an example, the interface element can either be provided as a part separate from the first and second peripheral connectors, or one interface element can be provided for each of the first and second peripheral connectors. When designing the interface element as a separate part, same can for instance be fabricated as a surface mount device (SMD) component which is mounted directly on the printed circuit board before assembling the printed circuit board within the housing. Consequently, a particularly well-defined and robust connection can be established between the interface element and the PCB.

Alternatively, each of the first and second peripheral connectors can be provided with an interface element. Such a construction is for instance advantageous in combination with an edge clamping electrical contact between the interface element and the PCB. For this variant the interface element is assembled with the respective first and second peripheral connectors already when compiling the electrical connector kit according to an example. A further advantage of this construction can be seen in the fact that less separate parts have to be stockpiled and handled at the facility where the sensors are assembled.

In order to securely fix the first or second peripheral connector at the interface element and/or the circuit carrier, locking means can be provided at the peripheral connectors. The locking means can for instance comprise a snap-fit connection. According to an example, this snap-fit connection does not necessarily have to be detachable because once the sensor is assembled, same usually needs not be disassembled again. Advantageously, the snap-fit connection is established between a snap-fit hook arranged at the peripheral connector and a mating recess provided at the housing of the sensor.

The interface element can be attached to the circuit carrier in various different ways. A particularly space saving arrangement can be achieved by forming the interface element as a surface mount device (SMD) component which is connected to the circuit carrier for instance by means of reflow soldering. Moreover, the soldered connection provides a particularly robust and low ohmic electrical contact. Alternatively, the interface element may also be attached to the printed circuit board by means of the press-fit connection. Furthermore, when pre-assembling the interface element with each of the first and second peripheral connectors, a particularly simple and reliable way of connecting the interface element to the circuit carrier is to provide electrically conductive spring contacts for being connected to contacts arranged at an edge of the circuit carrier by means of a force fit. By providing respective guiding means, a correct mating of the interface element and the circuit carrier can be ensured.

According to an example, sealing means can be provided at the peripheral connectors so that a housing of the electronic circuitry is closed in a watertight and dustproof way after the peripheral connector is assembled. Consequently, no overmolding ("potting") is mandatory anymore. However, for certain applications it can still be useful to fill the housing with a casting resin. In this case and when using spring contacts, casting resin might enter between the spring contact and the circuit carrier, thereby deteriorating the electrical contact. It could be shown that this effect can be avoided by providing a protective cover at the interface element that protects the inner contacts against the intrusion of potting material.

The advantages of an example may best be used for an electronic component having a housing with an essentially cylindrical shell that at least partly encompasses the circuit carrier. The first and second peripheral connectors can be formed as a cover to close the shell, so that the electronic circuitry is effectively protected against the ingress of moisture and dust. Moreover, the cylindrical shell may at least partly be formed from an electrically conductive material, for instance metal, so that it provides a shielding of the sensor electronics against interfering signals.

The cylindrical shell may further comprise an additional electrically insulating end cap for receiving the first or second peripheral connector. Such an end cap could contain sensor specific display and input means, for instance light emitting diodes, potentiometers, and/or push buttons.

A method for assembling an electronic component according to an example comprises the step of attaching an interface element to a circuit carrier, so that at least one inner contact is contacting at least one electrically conductive lead on said circuit carrier, said interface element further comprising an electrically connecting interface for contacting a peripheral connector. The method further comprises the step of connecting either the first or the second peripheral connector to said connecting interface, wherein the first and second peripheral connectors have peripheral contact elements for contacting an external electronic component which differ from each other. In particular, either a plug connector or an electrical lead can thus be attached to the electronic component at an instant towards the end of the assembly process.

The sequence of these two steps according to an example depends on the particular example of the interface element. In particular, for an interface element that is formed as an SMD component or is equipped with press-fit pins, the interface element has to be mounted at the circuit carrier before attaching the peripheral connector. On the other hand, for the example of a clamping spring contact at the interface element it is advantageous to provide such an interface element at each peripheral connector before mounting same at the circuit carrier.

In any case, the choice what sort of peripheral connector is to be mounted at the sensor component can be postponed until the very last assembly steps.

In the foregoing, reference was always made to using the electrical connector kit with sensors and in particular with inductive proximity sensors. However, it is apparent for a person skilled in the art that the idea according to an example may also be used for any other kind of sensors or generally to other electronic components comprising circuit carriers having the need of peripheral contact elements for connecting the electronic component to external electronic components.
- **FIG. 1**: shows schematically a sectional view of an inductive proximity sensor with a peripheral plug connector according to an example;
- **FIG. 2**: shows schematically a sectional view of an inductive proximity sensor with a peripheral pigtail lead according to an example;
- **FIG. 3**: shows a first assembly step for assembling the arrangement according to Figures 1 and 2;
- **FIG. 4**: shows a further assembly step for assembling the arrangement according to Figures 1 and 2;
- **FIG. 5**: shows a further assembly step for assembling the arrangement according to Figures 1 and 2;
- **FIG. 6**: shows a further assembly step for assembling the arrangement according to Figures 1 and 2;
- **FIG. 7**: shows a perspective view of a peripheral plug connector and an interface element according to the invention;
- **FIG. 8**: shows the arrangement of Fig. 7 rotated by 90°;
- **FIG. 9**: shows schematically the position of the circuit carrier for the arrangement of Fig. 7;
- **FIG. 10**: shows the arrangement of Fig. 9 rotated by 180°;
- **FIG 11**: shows the arrangement of Fig. 7 without the protective cover;
- **FIG. 12**: shows the arrangement of Fig. 11 in a rotated position;
- **FIG. 13**: shows a perspective exploded view of the peripheral plug connector and interface element according to Fig. 7;
- **FIG. 14**: shows a perspective view of a peripheral pigtail connector and an interface element according to the invention;
- **FIG. 15**: shows the arrangement of Fig. 14 in a rotated position;
- **FIG. 16**: shows an arrangement of Fig. 14 in an exploded view, this arrangement being outside the invention;
- **FIG. 17**: shows a further partly exploded view of an arrangement of Fig. 14, this arrangement being outside the invention;
- **FIG. 18**: shows a perspective view of a peripheral cable connector and an interface element according to an example;
- **FIG. 19**: shows the arrangement of Fig. 18 rotated by 180°;
- **FIG. 20**: shows an arrangement of Fig. 18 in an exploded view, this arrangement being outside the invention;
- **FIG. 21**: shows a perspective view of a peripheral cable connector with an interface element according to a further example not according to the invention;
- **FIG. 22**: shows the arrangement of Fig. 21 rotated by 90°;
- **FIG. 23**: shows the arrangement of Fig. 21 in another rotated view;
- **FIG. 24**: shows a perspective view of a peripheral plug connector according to a further example not according to the invention;
- **FIG. 25**: shows an interface element to be connected with the peripheral plug connected according to Fig. 24;
- **FIG. 26**: shows the interface element of Fig. 25 and the belonging peripheral plug connector of Fig. 25 before being connected;
- **FIG. 27**: shows the arrangement of Fig. 21 in an exploded view;
- **FIG. 28**: shows an example of a peripheral plug connector using the interface element according to Fig. 25;
- **FIG. 29**: shows the arrangement of Fig. 28 rotated by 90°;
- **FIG. 30**: shows the arrangement of Fig. 28 in an exploded view;
- **FIG. 31**: shows an assembly step for fabricating the interface element of Fig. 25;
- **FIG. 32**: shows a final step for fabricating the interface element of Fig. 25.

Examples will now be explained in more detail with reference to the Figures.

Referring now to Fig. 1, an electronic component 100, in particular a sensor, is shown which is assembled using an electrically connector kit according to an example. The sensor 100 comprises a circuit board 102 which is for instance a printed circuit board (PCB) as known to a person skilled in the art. The circuit board 102 carries electronic components (not shown in this Figure) and transducer elements, such as a sensor coil in case the sensor 100 is an inductive proximity switch. A housing 104 encompasses the circuit board 102 and the components assembled thereon.

According to an example, an interface element 106 is mounted on the circuit carrier 102. The interface element 106 is electrically connected to the circuit carrier 102 by means of at least one inner contact 108. In the present case, a plurality of inner contacts 108 are provided at the interface element 106, each of them being connected to a connecting interface 110.

The connecting interface 110 is formed to be connected either with a peripheral plug connector 112 as shown in Fig. 1 or to a peripheral lead connector 114 as shown in Fig. 2. Of course, any other suitable alternative of how the peripheral connector can be formed is also covered by the present invention. For instance, the peripheral plug connector 112 can be formed to comply to the M12 5-position male connector according to the standard "Connectors for electronic equipment- Product requirements - Part 2-101: Circular connectors - Detail specification for M12 connectors with screw-locking" (IEC 61076-2-101:2012). A respective thread 116 for mechanically fixing the belonging mating connector is provided at the outside of a plastic cap 118.

Locking means 120 are provided for mechanically fixing the peripheral connector 112 at the interface element 106 and therefore also at the PCB 102. As schematically shown in Fig. 1, the locking means 120 comprise a ring-shaped or hook-shaped snap-in connector. According to an example, this snap-fit connection does not have to be releasable after the peripheral connector has been assembled.

The connecting interface 110 between the interface element 106 and the peripheral connector 112 or 114 is advantageously formed by a press-fit connection. The electrical connection between the interface element 106 and conductive tracks on the PCB 102 may for instance be established by means of reflow soldering. In particular, the interface element 106 can be formed as an SMD (surface mount device) component. However, it is clear for a person skilled in the art that also other suitable ways of contacting the PCB 102 can be employed at this point.

According to the example shown in Figures 1 to 6, the PCB 102 is mounted within an M12, M18, or M30 metal housing 104. Such a metal housing has the advantage that the electronic circuitry inside the housing 104 is protected against disturbing signals from the outside. Forming the housing 104 from two separate parts, namely an elongated metal shell 122 and a separate plastic cap 118, has the advantage that more complicated geometries for display and control elements can easily be combined with a shielding structure. The plastic cap 118 may for instance be formed as an injection molded part.

Fig. 2 shows the same electronic component 100 which in contrast to the arrangement of Fig. 1 is not equipped with a peripheral plug connector 112, but with the peripheral lead connector 114. This different peripheral connector 114 carries a cable 124, and the sensor 100 therefore forms a so-called pigtail. It has to be noted that the other end of the cable 124 may carry any suitable connector for contacting an external device (not shown in the Figures). The cable 124 may be a flat flexible cable, a coaxial cable, or any other electrical lead as required for contacting the external device.

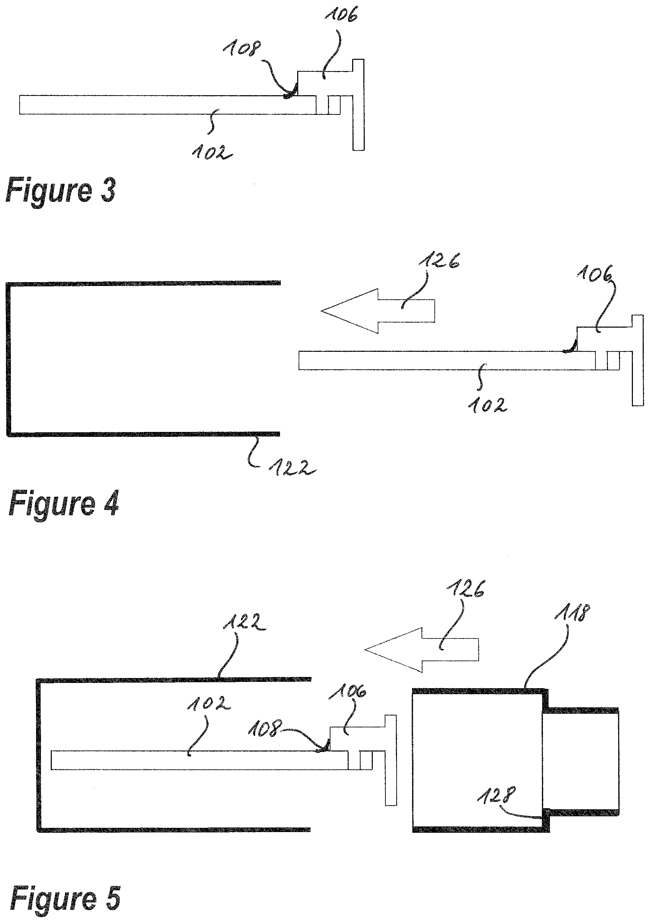

Figures 3 to 6 illustrate an example of an assembly method using an electrical connector kit according to an example. As shown in Fig. 3, according to a first example, the circuit carrier 102 is equipped with an interface element 106. The inner contacts 108 are connected to electrical leads on the circuit carrier 102 for instance by means of reflow soldering. As shown in Fig. 4, the printed circuit board 102 with the assembled interface element 106 is inserted into an essentially cylindrical metal shell 122 in a direction 126 along a longitudinal axis of the electronic component. The metal shell 122 has suitable guiding means (not shown in the Figures) for guiding and holding the PCB 102.

In a next step (see Fig. 5) a plastic cap 118 is inserted along the same direction 126 corresponding to the longitudinal axis of the electronic component. As will become more apparent from the following Figures, the plastic end cap 118 comprises a circumferential shoulder 128 for interacting with the locking means 120 of the peripheral connectors 112, 114.

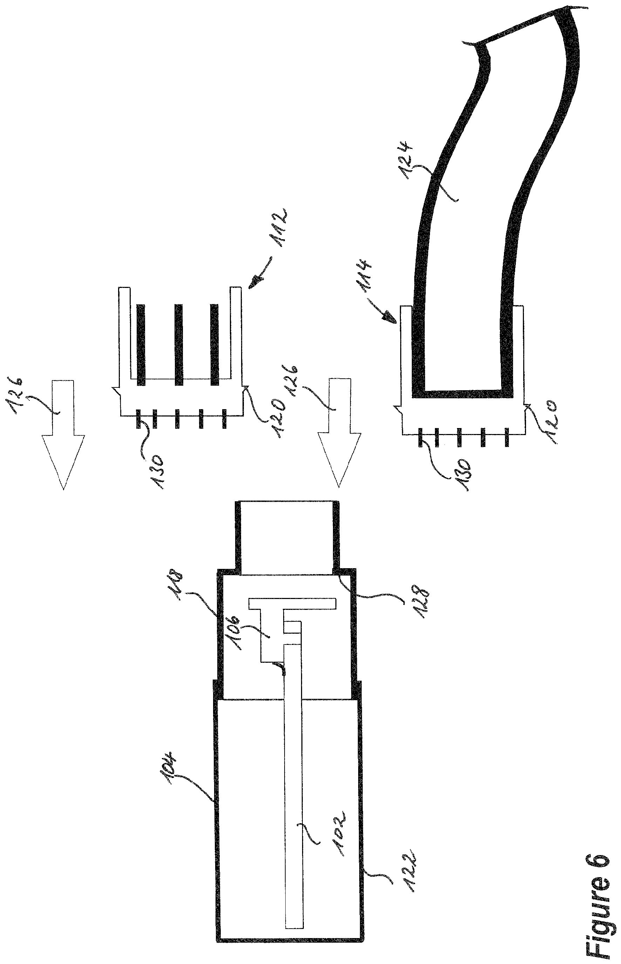

Fig. 6 shows the point in the assembly procedure when it is determined whether the electronic component 100 is equipped with the peripheral plug connector 112 or with the peripheral lead connector 114. According to an example, the electrical connector kit comprises in addition to the interface element 106 also a set of at least one first and second peripheral connector 112, 114 which selectively can be connected to the interface element 106. As shown in the drawing, either a plug connector 112 or a lead connector 114 having a cable 124 can be attached to the interface element 106.

The respective peripheral connector 112, 114 is inserted along the longitudinal axis of the electronic component 100. A circumferential snap-fit element is provided as locking means 120 and engages with the shoulder 128 at the end cap 118 in an essentially irreversible manner. In addition to the peripheral connectors 112, 114 shown in Fig. 6, of course also other peripheral connectors can be part of the electrical connector kit. For instance, means for a wireless connection, a plug connector socket, or another type of pin connector can be provided.

In the example shown in Fig. 6, the peripheral connectors 112, 114 are equipped with press-fit contacts 130 that connect the respective peripheral connector 112, 114 to the connecting interface 110 of the interface element 106. However, also abutting spring contacts can be used instead of the press-fit contacts 130.

The connection between the respective peripheral connector 112, 114 and the plastic end cap 118 can be designed in a way that the housing 104 is closed in a watertight and dustproof way. Alternatively, an additional casting step may also be performed for sealing the arrangement.

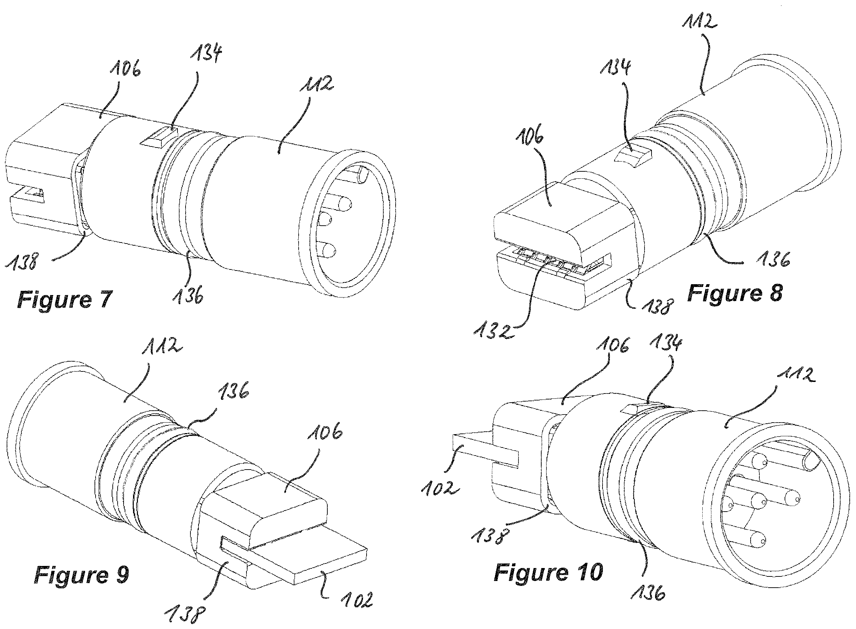

A further advantageous example will be described with reference to Figures 7 to 20. This example mainly differs from the previous example in that an interface element 106 is first connected to each of the peripheral connectors 112, 114, and that the connection between the interface element 106 and the circuit carrier 102 is established in the same step when assembling the peripheral connectors 112, 114.

This example has the advantage that firstly the amount of lose parts belonging to the electrical connector kit is reduced and that secondly the proprietary components belonging to the harnessing and peripheral contacts are introduced into the process of fabricating an electronic sensor component even later in the process sequence.

Figures 7 to 10 show a peripheral plug connector 112 with an attached interface element 106. According to this particular example, the interface element 106 is formed to engage with a PCB 102 in a clamping manner. To this end, the interface element 106 comprises spring contacts 132 which engage with contact areas (not shown in the Figures) provided on the printed circuit board 102.

A snap-fit projection 134 is formed at the outside of the peripheral plug connector 112 for engaging with a belonging recess or shoulder provided at the sensor housing. Moreover, a ring-shaped gasket 136 seals the mechanical interface between the housing and the inserted peripheral plug connector 112 in the final mounted state.

The spring contacts 132 are pushed over the printed circuit board 102 and establish an electrical contact due to the spring forces of the contact 132. These forces mainly are oriented across to the insertion direction 126. However, when overmolding the circuit carrier 102 by filling a cast resin into the housing (not shown in the Figures), electrically insulating material can enter between the spring contacts 132 and the printed circuit board 102, thereby deteriorating the quality of the electrical contact. Consequently, the interface element 106 comprises a cover 138 for protecting the spring contacts 132 against the ingress of the cast resin. Preferably, the cover 138 is fabricated from an elastic material, so that it is in tight contact with the PCB 102 before the cast resin is filled in.

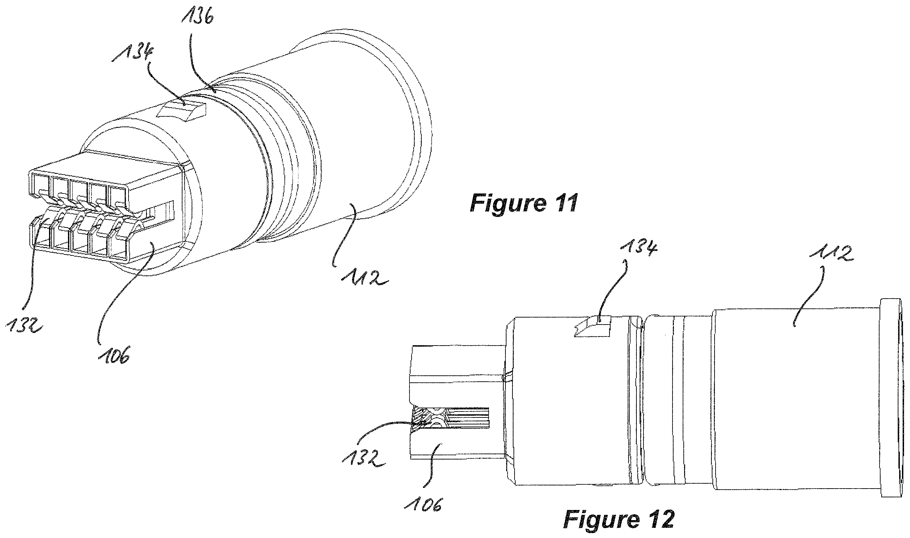

Figures 11 and 12 show the contact area of the interface element 106 without the cover 138.

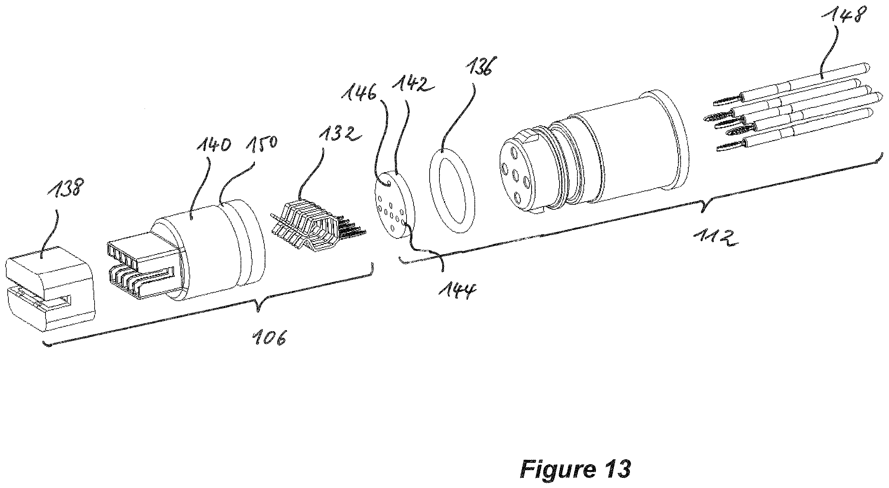

Fig. 13 shows an exploded view of the components forming the arrangement of Fig. 7. In particular, the interface element 106 comprises spring contacts 132 which are assembled in the contact carrier 140. In order to form a connecting interface 110 towards the peripheral plug connector 112, the spring contacts 132 are connected to an intermediate circuit board 142. The intermediate circuit board 142 has metallized contact openings 144 (vias) for receiving the spring contacts 132. Moreover, the intermediate circuit board 142 is provided with a second plurality of metallized openings 146 (vias) which receive the plug connector pins 148 of the peripheral plug connector 112. Conducting paths (not shown in the Figures) are provided in the intermediate circuit board 142 that interconnect the vias 144, 146 and thereby electrically connect the spring contacts 132 with the belonging connector pins 148.

As already mentioned, the gasket 136 (which is to be arranged in a groove 150) seals the interface between the housing and the interface element 106.

Fig. 14 to 17 show the belonging peripheral lead connector that belongs to the same connector kit as the plug connector 112 shown in Figures 7 to 13.

As can be seen in Figures 14 and 15, the interface towards the PCB 102 is identical and shows spring contacts 132 that contact the PCB 102 by clamping it from two sides at the edge. An elastic protective cover 138 is provided for preventing that casting resin is drawn by capillary forces into the minute gap between the PCB 102 and the spring contacts 132.

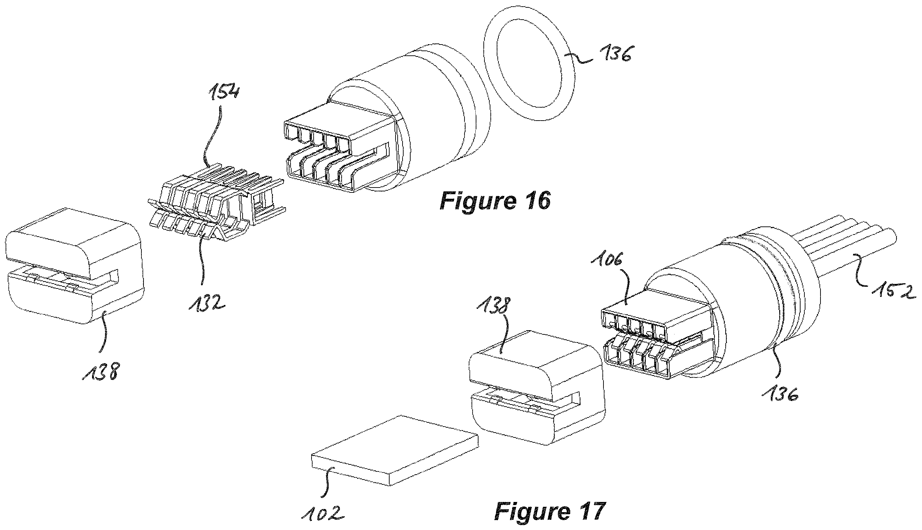

In contrast to the peripheral plug connector 112 shown in Figures 7 to 13, the peripheral lead connector 114 comprises a plurality of electrically insulated wires 152 with a conductive core. The wires 152 may either be attached to the peripheral lead connector 114 as single leads or may form a ribbon cable. Although an arrangement with an intermediate circuit board 142 as shown in Figures 13 may also be used for fabricating the peripheral lead connector 114 of Figures 14 and 15, it is even more efficient but outside the scope of the invention to directly connect the wires 152 to the spring contacts 132. This example not according to the invention is illustrated in Figures 16 and 17. In particular, the spring contacts 132 have insulation displacement terminations 154 for cutting the insulation of the wires 152 and electrically connecting the conductive cores of the wires 152.

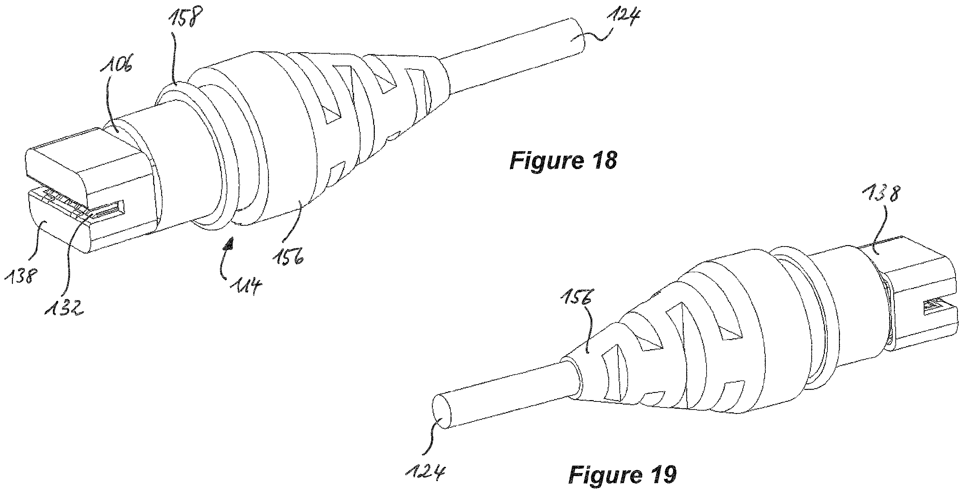

A further peripheral lead connector 114 with an attached interface element 106 is depicted in Figures 18 to 20. According to this example, the outgoing cable 124 is protected by a tension relief 156. Furthermore, the tension relief 156 is formed of an elastic material and comprises a sealing rim 158 which can replace the gasket 136.

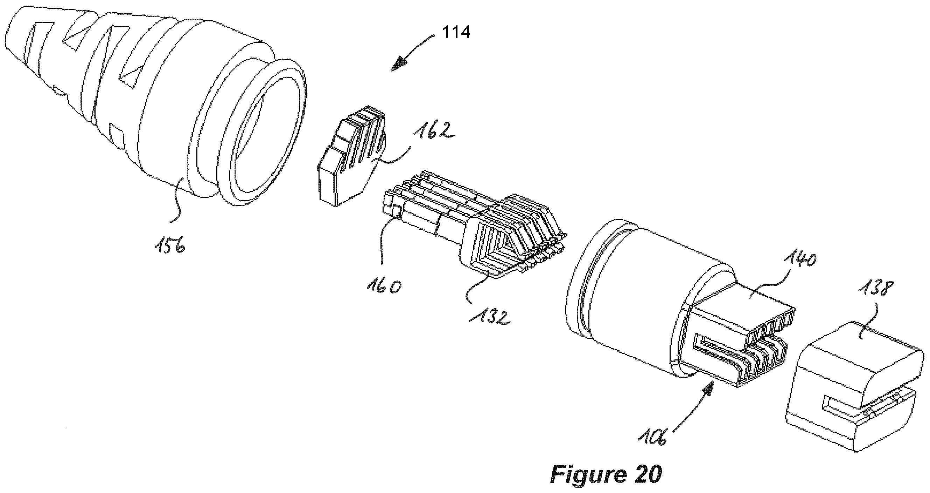

Fig. 20 illustrates a further possibility, not according to the invention, of attaching the wires of the cable 124 to the spring contacts 132. According to this example, the spring contacts have crimp regions 164 for attaching the individual wires of the cable. For fabricating the arrangement shown in Fig. 18, the ends of the wires (not shown in Fig. 20) are first stripped from their insulation and then crimped individually to one spring contact 132 each. The spring contacts 132 are then arranged in holder 162 and inserted into the contact carrier 140. Next, the protective cover 138 and the tension release 156 are attached. This arrangement provides a combined peripheral plug connector 112 with an interface element 106.

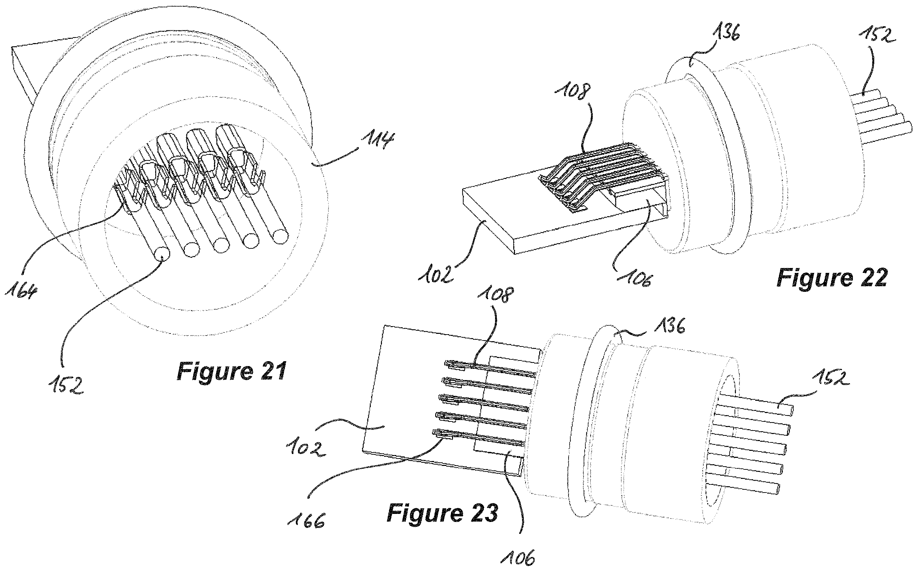

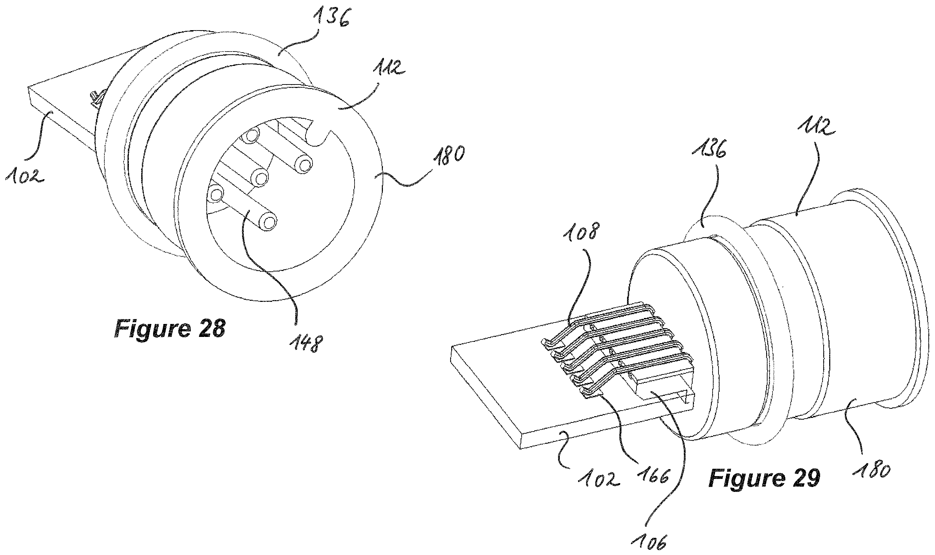

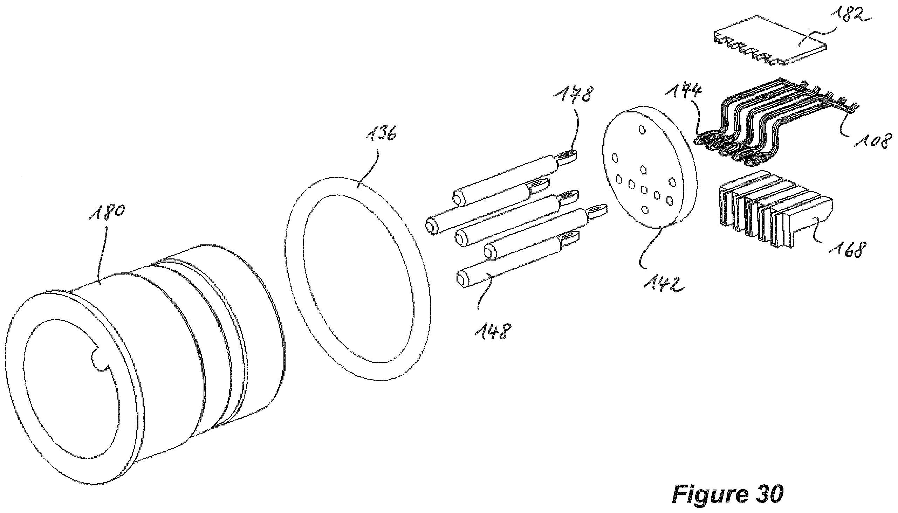

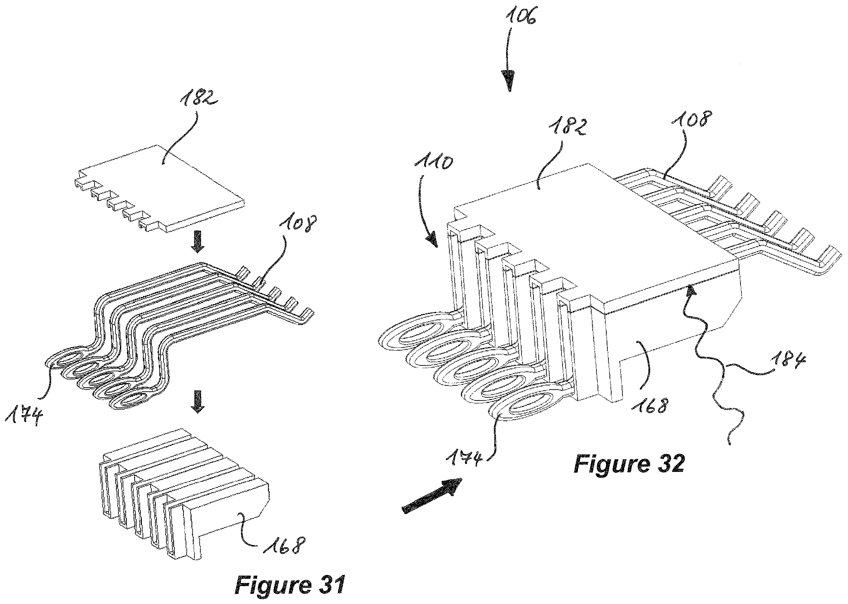

Figures 21 to 32 illustrate a further advantageous example of a connector kit not according to the invention. Figures 21 to 27 relate to the peripheral lead connector 114 whereas Figures 28 to 30 show the corresponding peripheral plug connector 112. Figures 31 and 32 illustrate the assembly of the interface element 106.

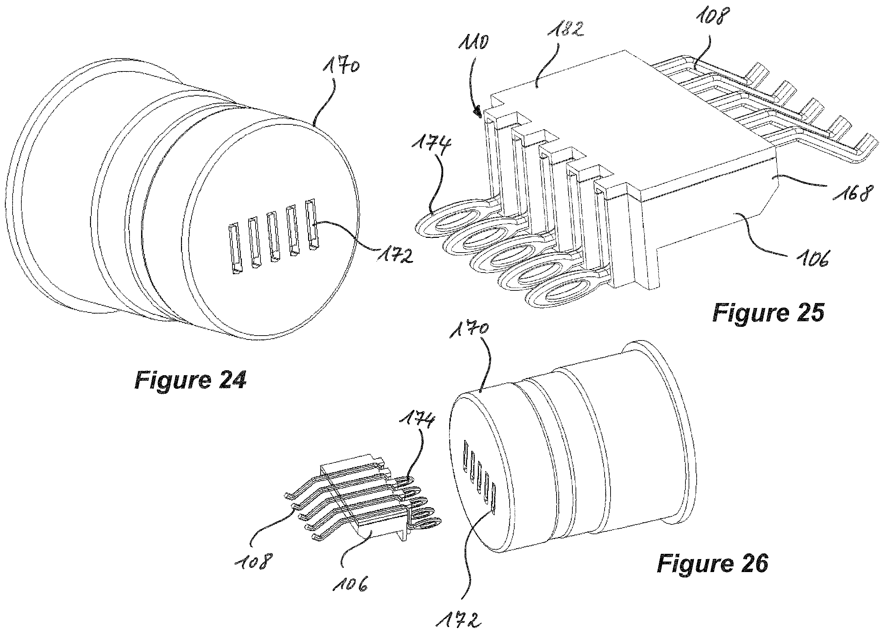

As shown in Fig. 21, the wires 152 are attached by means of crimp connections 164 to the peripheral lead connector 114. The interface element 106 comprises inner contacts 108 that are soldered to the respective contact pads 166 provided at the PCB 102. As becomes more apparent from Fig. 25, the interface element 106 comprises an electrically insulating body 168 and a plurality of inner contacts 108 that provide a connecting interface 110 for the peripheral plug connector 112. An electrically insulating housing 170 of the peripheral plug connector has receptacles 172 through which EON (eye-of-the-needle) contacts 174 can be inserted. Fig. 26 shows the arrangement before being plugged together.

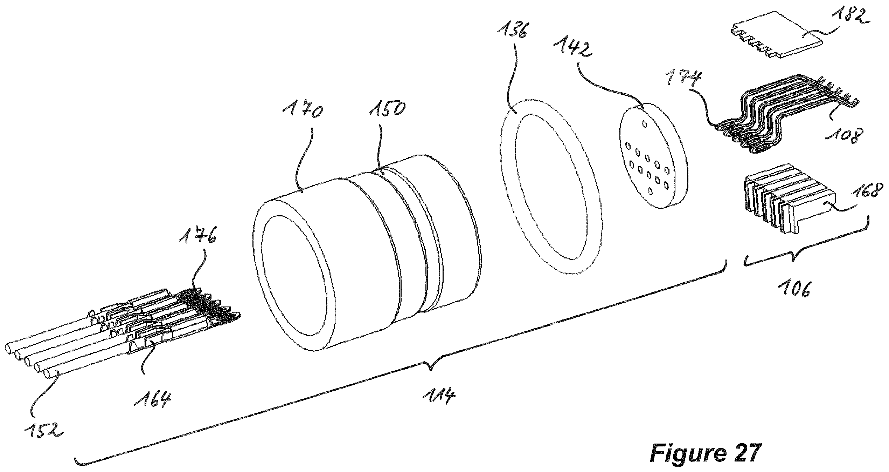

Fig. 27 illustrates in an exploded view how the interface element 106 contacts the peripheral lead connector 114 with its EON contacts 174. Similar to the example shown in Fig. 13, an intermediate circuit board 142 is provided within the housing 170 of the peripheral connector. Wires 152 are fixed by crimp connections 164 to further EON contacts 176. After the interface element 106 is soldered to the PCB 102, same is mounted within a housing (as shown in Fig. 5). The peripheral lead connector 114 is assembled by attaching the wires 152 at the intermediate circuit board 142 contained within the housing 170. Finally, the peripheral lead connector 114 is connected to the EON contacts 174 by inserting the lead connector 114 partly into the housing 104.

Figures 28 to 30 depict the corresponding peripheral plug connector 112. The construction of the plug connector 112 is similar to the design of the lead connector 114, with the exception that the housing is formed to hold plug connector pins 148 which are connected to an intermediate circuit board 142 by EON contacts 178. The connector housing 180 of the peripheral connector 112 has identical receptacles 172 for receiving the contacts 174 of the interface element 106. A suitable wiring provided within the intermediate circuit board 142 provides the connection between the inner contacts 108 and the pins 148.

Fig. 31 and 32, finally, illustrate the fabrication of the interface element 106 with solderable inner contacts 108 and eye-of-the-needle contacts 174 at the connecting interface 110.

Firstly, the EON contacts 174 are fabricated as one single part with the inner contacts 108. These contacts are then arranged in an electrically insulating body 182. A cover 182 is mounted on the body 168 in order to fix the contact at the body and an ultrasonic welding step (illustrated by the arrow 184) connects the cover 182 to the body 168.

An electrical connector kit for a circuit carrier 102 according to an example comprises at least one interface element 106 and at least one of the peripheral plug connector 112 and the peripheral lead connector 114. Consequently, when assembling an electronic component such as an inductive proximity switch, the decision whether a lead connector or a plug connector has to be mounted can be made towards the end of the assembly process. Is clear for a person skilled in the art that further peripheral connectors may of course also be provided with the electrical connector kit.

**REFERENCE NUMERALS**

| **Reference Numeral** | **Description** |
|---|---|
| 100 | Electronic component |
| 102 | Circuit carrier (PCB) |
| 104 | Housing |
| 106 | Interface element |
| 108 | Inner contact |
| 110 | Connecting interface |
| 112 | Peripheral plug connector |
| 114 | Peripheral lead connector |
| 116 | Thread |
| 118 | Plastic end cap |
| 120 | Locking means |
| 122 | Metal shell |
| 124 | Cable |
| 126 | Inserting direction |
| 128 | Shoulder at end cap |
| 130 | Press-fit contact |
| 132 | Spring contact |
| 134 | Snap-fit projection |
| 136 | Ring-shaped gasket |
| 138 | Protective cover |
| 140 | Contact carrier |
| 142 | Intermediate circuit board |
| 144 | First metallized opening |
| 146 | Second metallized opening |
| 148 | Plug connector pins |
| 150 | Groove |
| 152 | Wire |
| 154 | Insulation displacement termination |
| 156 | Tension relief |
| 158 | Sealing rim |
| 160 | Crimp region |
| 162 | Holder |
| 164 | Crimp connection |
| 166 | Contact pad |
| 168 | Body of interface element |
| 170 | Housing of peripheral lead connector |
| 172 | Receptacle |
| 174 | EON contact of interface element |
| 176 | EON contact of peripheral connector |
| 178 | EON contact of pin |
| 180 | Housing of peripheral plug connector |
| 182 | Cover of interface element |

## Claims

1. Electrical connector kit for attaching one of at least a first or a second peripheral connector (112, 114) to a printed circuit board (102) of an inductive proximity sensor, said connector kit comprising:
at least one interface element (106) which is attachable to said printed circuit board (102) for contacting at least one electrically conductive lead on said printed circuit board (102), said interface element (106) further comprising an electrically connecting interface (110) for contacting said at least one first or second peripheral connector (112, 114),
the connector kit being **characterised in that** it further comprises a set of at least one first and second peripheral connectors (112, 114), each having press-fit contacts (130) being connectable to said connecting interface (110),
wherein, for contacting at least one external electronic component, said first and second peripheral connectors (112, 114) have peripheral contact elements which differ from each other, wherein the peripheral contact element of the first peripheral connector (112) comprises plug connector pins (148), and wherein the peripheral contact element of the second peripheral connector (114) comprises an electrical lead (152, 124) attached thereto, and
wherein the interface element (106) comprises spring contacts (132) which engage with contact areas provided on the printed circuit board (102) in a clamping manner, and wherein said interface element (106) comprises a cover (138) for protecting said electrically conductive spring contacts (132) against ingress of cast resin.

2. Electrical connector kit according to claim 1, comprising one interface element (106) for each of the said first and second peripheral connectors (112, 114).

3. Electrical connector kit according to claim 1, wherein said first and second peripheral connectors (112, 114) comprise a snap-fit projection (134) for mechanically securing the peripheral connectors (112, 114) in a mounted state.

4. Electronic component (100) comprising
one printed circuit board (102), and
an electrical connector kit according to one of the preceding claims,
the spring contacts (132) of the interface element (106) engaging with contact areas provided on the printed circuit board (102) in a clamping manner, and
the press-fit contacts (130) of one of the first or the second peripheral connector (112, 114) being connected to said connecting interface (110) of the interface element (106) .

5. Electronic component according to claim 4, wherein said printed circuit board (102) comprises at least one inductive proximity sensor.

6. Electronic component according to one of the claims 4 or 5, further comprising a housing (104) that at least partly encompasses said printed circuit board (102).

7. Electronic component according to claim 6, wherein said housing (104) comprises an essentially cylindrical shell (122, 118), and wherein said first and second peripheral connectors (112, 114) are formed as a cover to close said shell (122, 118).

8. Electronic component according to claim 7, wherein said cylindrical shell (122, 118) comprises an electrically conductive shielding part (122) and an electrically insulating end cap (118) for receiving said first or second peripheral connector (112, 114).

9. Method for assembling an electronic component according to one of the claims 4 to 8, the method comprising the following steps:
attaching an interface element (106) to a printed circuit board (102), so that the spring contacts (132) of the interface element (106) engage with contact areas provided on said printed circuit board (102) in a clamping manner,
said interface element (106) further comprising an electrically connecting interface (110) for contacting the at least one first or second peripheral connector (112, 114);
connecting either the first or the second peripheral connector (112, 114) to said connecting interface (110), wherein said first and second peripheral connectors (112, 114) have peripheral contact elements for contacting an external electronic component which differ from each other.

10. Method according to claim 9, wherein one interface element (106) is attached as a separate element to the printed circuit board (102) before mounting either the first or second peripheral connector (112, 114), or wherein one interface element (106) is attached to each of the first and second peripheral connectors (112, 114) before being mounted at the printed circuit board (102).

## Patentansprüche

1. Bausatz für elektrischen Verbinder zum Anbringen eines ersten oder/und eines zweiten Peripherie-Verbinders (112, 114) an einer Leiterplatte (102) eines induktiven Näherungssensors, wobei der Verbinder-Bausatz umfasst:
wenigstens ein Schnittstellenelement (106), das an der Leiterplatte (102) angebracht werden kann, um Kontakt mit wenigstens einer elektrisch leitenden Leitung an der Leiterplatte (102) herzustellen, wobei das Schnittstellenelement (106) des Weiteren eine elektrisch verbindende Schnittstelle (110) zum Herstellen von Kontakt mit dem ersten oder/und zweiten Peripherie-Verbinder (112, 114) umfasst, wobei der Verbinder-Bausatz **dadurch gekennzeichnet ist, dass** er des Weiteren umfasst:
einen Satz aus einem ersten oder/und zweiten Peripherie-Verbinder (112, 114), die jeweils Presspass-Kontakte (130) aufweisen, die mit der verbindenden Schnittstelle (110) verbunden werden können,
wobei zum Herstellen von Kontakt mit wenigstens einem externen elektronischen Bauteil der erste und der zweite Peripherie-Verbinder (112,114) Peripherie-Kontaktelemente aufweisen, die sich voneinander unterscheiden, wobei das Peripherie-Kontaktelement des ersten Peripherie-Verbinders (112) Steckverbinder-Stifte (148) umfasst, und das Peripherie-Kontaktelement des zweiten Peripherie-Verbinders (114) eine daran angebrachte elektrische Leitung (152, 124) umfasst, und
wobei das Schnittstellenelement (106) Federkontakte (132) umfasst, die mit an der Leiterplatte (102) vorhandenen Kontaktbereichen klemmend in Eingriff kommen, und wobei das Schnittstellenelement (106) eine Abdeckung (138) zum Schützen der elektrisch leitenden Federkontakte (132) gegen Eindringen von Gießharz umfasst.

2. Bausatz für elektrischen Verbinder nach Anspruch 1, der ein Schnittstellenelement (106) für jeden von dem ersten und dem zweiten Peripherie-Verbinder (112, 114) umfasst.

3. Bausatz für elektrischen Verbinder nach Anspruch 1, wobei der erste und der zweite Peripherie-Verbinder (112, 114) einen Einrast-Vorsprung (134) zum mechanischen Sichern der Peripherie-Verbinder (112, 114) in einem montierten Zustand umfassen.

4. Elektronisches Bauteil (100), das umfasst:
eine Leiterplatte (102), sowie
einen Bausatz für elektrischen Verbinder nach einem der vorangehenden Ansprüche,
wobei die Federkontakte (132) des Schnittstellenelementes (106) mit an der Leiterplatte (102) vorhandenen Kontaktbereichen klemmend in Eingriff kommen, und
die Presspass-Kontakte (130) des ersten oder des zweiten Peripherie-Verbinders (112, 114) mit der verbindenden Schnittstelle (110) des Schnittstellenelementes (106) verbunden sind.

5. Elektronisches Bauteil nach Anspruch 4, wobei die Leiterplatte (102) wenigstens einen induktiven Näherungssensor umfasst.

6. Elektronisches Bauteil nach einem der Ansprüche 4 oder 5, das des Weiteren ein Gehäuse (104) umfasst, das die Leiterplatte (102) wenigstens teilweise umschließt.

7. Elektronisches Bauteil nach Anspruch 6, wobei das Gehäuse (104) eine im Wesentlichen zylindrische Schale (122, 118) umfasst, und wobei der erste und der zweite Peripherie-Verbinder (112, 114) als eine Abdeckung zum Verschließen der Schale (122, 118) ausgebildet sind.

8. Elektronisches Bauteil nach Anspruch 7, wobei die zylindrische Schale (122, 118) ein elektrisch leitendes Abschirmteil (122) sowie eine elektrisch isolierende Endkappe (118) zum Aufnehmen des ersten oder zweiten Peripherie-Verbinders (112, 114) umfasst.

9. Verfahren zum Montieren eines elektronischen Bauteils nach einem der Ansprüche 4 bis 8, wobei das Verfahren die folgenden Schritte umfasst:
Anbringen eines Schnittstellenelementes (106) an einer Leiterplatte (102), so dass die Federkontakte (132) des Schnittstellenelementes (106) mit an der Leiterplatte (102) vorhandenen Kontaktbereichen klemmend in Eingriff kommen,
wobei das Schnittstellenelement (106) des Weiteren eine elektrisch verbindende Schnittstelle (110) zum Herstellen von Kontakt mit dem ersten oder/und dem zweiten Peripherie-Verbinder (112, 114) umfasst;
Verbinden entweder des ersten oder des zweiten Peripherie-Verbinders (112, 114) mit der verbindenden Schnittstelle (110), wobei der erste und der zweite Peripherie-Verbinder (112, 114) Peripherie-Kontaktelemente zum Herstellen von Kontakt mit einer externen elektronischen Komponente aufweisen, die sich voneinander unterscheiden.

10. Verfahren nach Anspruch 9, wobei ein Schnittstellenelement (106) als ein separates Element an der Leiterplatte (102) angebracht wird, bevor entweder der erste oder der zweite Peripherie-Verbinder (112, 114) montiert wird, oder wobei ein Schnittstellenelement (106) jeweils an dem ersten und dem zweiten Peripherie-Verbinder (112, angebracht wird, bevor es an der Leiterplatte (102) montiert wird.

## Revendications

1. Kit de connecteurs électriques pour attacher l'un d'au moins un premier ou un deuxième connecteur périphérique (112, 114) à une carte de circuit imprimé (102) d'un capteur de proximité inductif, ledit kit de connecteurs comprenant :
au moins un élément d'interface (106) qui peut être attaché à ladite carte de circuit imprimé (102) pour entrer en contact avec au moins un fil électriquement conducteur sur ladite carte de circuit imprimé (102), ledit élément d'interface (106) comprenant en outre une interface de connexion électrique (110) pour entrer en contact avec ledit au moins un premier ou deuxième connecteur périphérique (112, 114),
le kit de connecteurs étant **caractérisé en ce qu'**il comprend en outre
un ensemble d'au moins un premier et un deuxième connecteurs périphériques (112, 114), chacun ayant des contacts à ajustement serré (130) pouvant être connectés à ladite interface de connexion (110),
dans lequel, pour entrer en contact avec au moins un composant électronique externe, lesdits premier et deuxième connecteurs périphériques (112, 114) ont des éléments de contact périphériques qui diffèrent l'un de l'autre, dans lequel l'élément de contact périphérique du premier connecteur périphérique (112) comprend des broches de connecteur enfichable (148), et dans lequel l'élément de contact périphérique du deuxième connecteur périphérique (114) comprend un fil électrique (152, 124) qui y est attaché, et
dans lequel l'élément d'interface (106) comprend des contacts à ressort (132) qui s'engagent avec des zones de contact prévues sur la carte de circuit imprimé (102) de manière serrée, et dans lequel ledit élément d'interface (106) comprend un couvercle (138) pour protéger lesdits contacts à ressort électriquement conducteurs (132) contre la pénétration de résine coulée.

2. Kit de connecteurs électriques selon la revendication 1, comprenant un élément d'interface (106) pour chacun desdits premier et deuxième connecteurs périphériques (112, 114).

3. Kit de connecteurs électriques selon la revendication 1, dans lequel lesdits premier et deuxième connecteurs périphériques (112, 114) comprennent une saillie à encliquetage (134) pour fixer mécaniquement les connecteurs périphériques (112, 114) dans un état monté.

4. Composant électronique (100) comprenant
une carte de circuit imprimé (102), et
un kit de connecteurs électriques selon l'une des revendications précédentes,
les contacts à ressort (132) de l'élément d'interface (106) s'engagent avec des zones de contact prévues sur la carte de circuit imprimé (102) de manière serrée, et
les contacts à ajustement serré (130) de l'un du premier ou du deuxième connecteur périphérique (112, 114) étant connectés à ladite interface de connexion (110) de l'élément d'interface (106).

5. Composant électronique selon la revendication 4, dans lequel ladite carte de circuit imprimé (102) comprend au moins un capteur de proximité inductif.

6. Composant électronique selon l'une des revendications 4 ou 5, comprenant en outre un boîtier (104) qui englobe au moins en partie ladite carte de circuit imprimé (102).

7. Composant électronique selon la revendication 6, dans lequel ledit boîtier (104) comprend une coque essentiellement cylindrique (122, 118), et dans lequel lesdits premier et deuxième connecteurs périphériques (112, 114) sont formés comme un couvercle pour fermer ladite coque (122, 118).

8. Composant électronique selon la revendication 7, dans lequel ladite coque cylindrique (122, 118) comprend une partie de blindage électriquement conductrice (122) et un capuchon d'extrémité électriquement isolant (118) pour recevoir ledit premier ou deuxième connecteur périphérique (112, 114).

9. Procédé d'assemblage d'un composant électronique selon l'une des revendications 4 à 8, le procédé comprenant les étapes suivantes :
attacher un élément d'interface (106) à une carte de circuit imprimé (102), de sorte que les contacts à ressort (132) de l'élément d'interface (106) s'engagent avec des zones de contact prévues sur ladite carte de circuit imprimé (102) de manière serrée,
ledit élément d'interface (106) comprenant en outre une interface de connexion électrique (110) pour entrer en contact avec l'au moins un premier ou un deuxième connecteur périphérique (112, 114) ;
connecter soit le premier soit le deuxième connecteur périphérique (112, 114) à ladite interface de connexion (110), dans lequel lesdits premier et deuxième connecteurs périphériques (112, 114) ont des éléments de contact périphériques pour entrer en contact avec un composant électronique externe qui diffèrent l'un de l'autre.

10. Procédé selon la revendication 9, dans lequel un élément d'interface (106) est attaché en tant qu'élément séparé à la carte de circuit imprimé (102) avant le montage du premier ou du deuxième connecteur périphérique (112, 114), ou dans lequel un élément d'interface (106) est attaché à chacun des premier et deuxième connecteurs périphériques (112, 114) avant d'être monté au niveau de la carte de circuit imprimé (102).
